# EUROPEAN PATENT APPLICATION

(11) **EP 1 648 057 A1**
(43) Date of publication of application: **19.04.2006**
(21) Application number: 04024396.6
(22) Date of filing: 13.10.2004
(51) Int. Cl.: H01S 5/024

(54) **Semiconductor laser device**

(71) Applicant: Harman Becker Automotive Systems GmbH, 76307 Karlsbad (DE)
(72) Inventor: Jurzitza, Dieter, Dr., 76131 Karlsruhe (DE)
(74) Representative: Schmuckermaier, Bernhard

(57) **Abstract**

A semiconductor laser device (101) comprising a light emitting material (108); means for causing said light emitting material to emit light; at least two mirrors (104,110) disposed on opposite sides of said light emitting material thereby forming an optical cavity inside which lasing occurs and from which output power is emitted; heating means (115) thermally coupled to said light emitting material for heating said light emitting material; and heating control means (204,206,304,306) electrically connected to said heating means and thermally connected to said light emitting material for maintaining a constant operating temperature of said light emitting material; said constant operating temperature is below the highest admissable operating temperature and above the highest operating temperature generated by the light emitting material alone.

## Description

### BACKGROUND OF THE INVENTION

### 1. Field of the Invention

The present invention relates to semiconductor lasers and more particularly to temperature compensation techniques for such lasers.

### 2. Description of the Prior Art

For most conventional semiconductor lasers, both the current threshold and the slope efficiency decrease monotonically and generally exponentially with increasing temperature of the light emitting material. However, one of the properties required with lasers as a light source is a good temperature characteristic. Specifically, if its performance significantly depends on the temperature, a constant light output is hard to achieve. In recent years, special semiconductor lasers, so-called vertical-cavity surface-emitting lasers (VCSELs), have been developed as, for example, a low-cost light source for high-speed data links. A typical VCSEL comprises a light emitting material, means for causing said light emitting material to emit light, and at least first and second mirrors disposed on opposite sides of said light emitting material thereby forming an optical cavity inside which lasing occurs and from which output power is emitted through said second mirror. VCSELs have a small light beam divergence which allows a high coupling efficiency with optical fibers but also have a temperature dependency of its light output power.

US 6,556,607 to Jewell discloses an approach for providing temperature compensation for semiconductor lasers which utilizes temperature depending reflectivity characteristics in at least one of the mirrors of the semiconductor laser to provide temperature compensation to the device.

US 6,687,280 to Kajita discloses a VCSEL substantially independent of a temperature which is achieved by a VCSEL comprising a surface light-emitting part comprising a resonator consisting of two multilayer reflectors and active layers inserted between two reflectors, and a waveguide part for introducing induced light near the surface light-emitting part.

US 6,341,138 to Peters et al. discloses a temperature insensitive VCSEL that includes an output mirror stack having a semiconductor distributed Bragg reflector and a dielectric distributed Bragg reflector, where a center wavelength of the semiconductor distributed Bragg reflector is different than a center wavelength of the dielectric distributed Bragg reflector.

US 5,497,389 to Kasukawa et al. provides a semiconductor laser device equipped with improved reflectors at the opposite ends of the resonator and capable of preventing any rise in the laser oscillation threshold current and reduction in the quantum efficiency due to temperature rise. Such laser device has an improved temperature dependency because its reflector loss is reduced as the device temperature rises.

The devices decribed above use temperature depending chracteristics of certain elements of the laser devices to achieve temperature compensation of the laser devices. Drawbacks of such devices result from temperature dependencies varying from device to device and from operating current to operating current.

A different approach is proposed by US 2004/0080811 (Shimizu et al.) and US 2004/0080814 (Ohki et al.) which provide heating and cooling means, preferrably a Peltier element, in a semiconductor device to maintain a constant device temperature for generating a constant wave length, wherein the Peltier element mainly functions as a cooler (see US 2004/0080814, section 0333). However, heating and cooling means as, for example, Peltier elements are costly and difficult to implement, particularly in view of the room required for the Peltier elements.

In view of the above described circumstances, it is therefore an object of the present invention to provide a semiconductor laser device insensitive to ambient temperature variations in a manner less costly and easier to implement.

### SUMMARY OF THE INVENTION

The present invention improves semiconductor laser devices by providing a heating mechanism to maintain a constant operating temperature below but close to the upper end of the operating temperature range of the semiconductor laser device. The inventive semiconductor laser device comprises a light emitting material; means for causing said light emitting material to emit light; at least two mirrors disposed on opposite sides of said light emitting material thereby forming an optical cavity inside which lasing occurs and from which output power is emitted; heating means thermally coupled to said light emitting material for heating said light emitting material; and heating control means electrically connected to said heating means and thermally connected to said light emitting material for maintaining a constant operating temperature of said light emitting material; said constant operating temperature is below the highest admissible operating temperature and above the highest operating temperature generated by the light emitting material alone at a maximum ambient temperature occurring.

Other objects and advantageous features of the invention will be apparent from the description and claims.

### BRIEF DESCRIPTION OF THE DRAWINGS

The invention will be more readily understood from the following description taken in connection with the accompanying drawings forming part thereof, in which:
- FIG 1: is a vertical sectional view of a semiconductor body of a semiconductor laser according to the invention;
- FIG 2: is circuit diagram illustrating an application of a laser device; and
- FIG 3: is circuit diagram illustrating an alternative application of a laser device.

### DETAILED DESCRIPTION

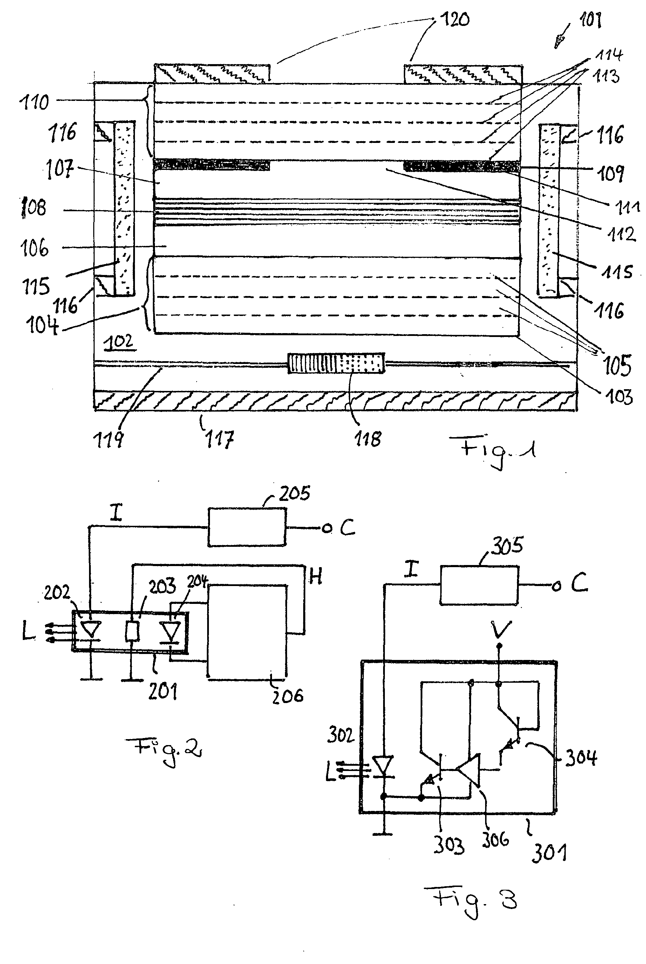

FIG 1 is a vertical sectional view of a semiconductor body of a semiconductor laser according to the invention. With reference to FIG 1, the semiconductor laser 101 comprises a substrate 102, a bottom mirror 104, an optional first spacer 106, an active region 108, an optional second spacer 107, an optional oxidation aperture 109 comprising optional non-oxidized portions 112 surrounded by oxidized portions 111, top mirrors 110 comprising low-index layers 113 and high-index layers 114, top contact 120, bottom contact 117, and interconnect metal 730. As may be seen by layers 113' and 114', mirrors 110 may be composed of differing materials. Mirrors 104 and 110, along with active region 108 and optionally one or more spacers, form an optical cavity. Of the light which escapes by transmission through the mirrors, by definition the majority of output light emits through the "output mirrors" which may be either top mirrors 110 or bottom mirrors 104. The mirrors opposite the output mirrors are referred to as the "non-output mirrors."

It should be appreciated that FIG 1 illustrates a vertical cavity surface emitting laser (VCSEL) but may represent any semiconductor laser constructed in accordance with the teachings of the present invention. Therefore, the particular structure of the laser is not of importance. Any semiconductor laser structure may be utilized with the teachings of the present invention so long as the laser has an active region light emitting material having, at least two mirrors. The inventive laser is preferrably a laser in which the cavity length is short enough for the laser to emit in only a single longitudinal mode. Thus, VCSELs are especially well suited for this invention.

A high-index material in a non-output mirror, in this example bottom mirrors 104, of a VCSEL may comprise a semiconductor whose absorption edge (bandgap) wavelength is very close to that of the cavity, or lasing, wavelength. One example is a VCSEL emitting in the 1.55 *µ*m region, grown on an InP substrate, in which the high-index mirror material comprises (In,Al,Ga)As having an absorption edge (or peak transition wavelength) at a wavelength slightly shorter, e.g., by 1 nm or more, than the lasing wavelength. Another example is an 850 nm VCSEL in which the high-index mirror material comprises (Al,Ga)As having a similar relation to the lasing wavelength. It is worthwhile to note that for a VCSEL, the absorption edge of the high-index mirror material may be at a wavelength that is longer than the peak transition wavelength of the active material.

Since VCSELs typically include gain-offset in the design, for either example the high-index mirror material may even comprise multiple quantum wells having the same composition as the VCSEL active region, or quantum wells having an absorption edge wavelength longer or shorter than that of the active region. In any of these examples the compensation of the STC works as follows. At low temperatures, there is appreciable light transmission through bottom mirrors 104, causing loss of the slope efficiency as measured from the output side of the VCSEL. As the temperature increases, the absorption edge wavelength of bottom mirrors 104 increases its wavelength much more rapidly than does the lasing wavelength. The refractive index of a material, especially a semiconductor, varies rapidly in the vicinity of the absorption edge. Thus, the temperature rise has the effect of increasing the refractive index of the high-index mirror material much faster than for the low-index material.

For example, the refractive index of the high-index mirror material will increase by a factor of 1.1 or more that the low-index material. Thus, the difference in refractive indices in the bottom mirror materials increases with increasing temperature, and so the reflectivity increases. This increase in reflectivity of the bottom mirror increases the light output through the output mirror. The reflectivity of the output mirror, in this example top mirror 110, is relatively constant. This increase in light output compensates for the normally occurring loss in output accompanying temperature rise due to quantum mechanical losses in the active region. The increasing reflectivity of bottom mirror 104 with temperature also has the effect of decreasing current threshold, and therefore adds to the role of gain offset (compensation for the otherwise monotonic increase in threshold with temperature).

The structure just described is particularly attractive for the production of VCSELs emitting at wavelengths 1.2 µm and longer which are grown on InP substrates. A bottom, non-output mirror 104 may be grown on an InP substrate. Low-index mirror layers 703 preferably comprise InP or InAlAs, which is approximately lattice-matched to InP. High-index layers 705 preferably comprise a material having a peak emission wavelength (or absorption edge wavelength) which is close to the laser emission wavelength. Suitable materials include InAlGaAs or InGaAsP with suitable compositions for approximate lattice matching to InP and the stated characteristics for peak emission wavelength or absorption edge wavelength. High-index layers may also comprise a variety of other materials having the desired properties. Examples include bulk (In, Al, Ga) (As, P, Sb, N), and multiple quantum wells comprising for example InGaAs/InAlGaAs. High-index layers may even comprise the same quantum well material used for active region 108. Preferably, non-output or bottom mirrors 104 are not intentionally doped. Optional first spacer 106 is preferably doped, for example n-doped (p-doped), and n-contact (p-contact) is preferably made to optional first spacer 106.

For efficient VCSEL operation with one mirror layer absorbing close to the lasing wavelength, it is preferable for the mirror layer to have a very low level of impurities, i.e., the material is preferably not intentionally doped. Since the temperature variation of refractive index varies more strongly closer to the absorption edge, it will be stronger at higher temperatures than at lower temperatures. Since the slope efficiency temperature coefficient is also stronger at higher temperatures, the same sign of nonlinearities in both processes help to maintain an overall more stable response also at larger temperatures.

A rough calculation of an example is now provided, making use of approximations reasonable for an example. Absent any compensation for temperature compensation in a well- designed 850 nm VCSEL, the slope efficiency at 70°C is typically about 80% of its value at 10°C. The back mirrors typically have near-unity reflectivity (R, near-zero transmission, or T) and the output mirrors are about 99.4% reflective (T ~ 0.6%). Under these conditions, the external differential quantum efficiency (DQE) is about 30% at 10°C, with essentially all the light emitting from the output mirror. Higher or lower DQE's are straightforwardly obtained by adjusting the reflectivities of the mirrors.

Now considering a VCSEL having back mirrors as described above with R = 99.8% (T = 0.2%), and output mirrors with T = 0.6%. Since the total mirror transmission loss is the same as before, the total external DQE is still about 30%. The ratio of the beam powers emitted from the two sides of the VCSEL is proportional to the mirror transmissions. Thus the backside DQE would be 10% and the output DQE is about 2/3 the total 20%. In this example, at a higher temperature, e.g. 70 °C., the back mirror reflectivity increases to > 99.9% (T < 0.1%) and the output mirror remains about constant. Due to lower overall mirror transmission loss, the overall DQE is lower, e.g., < 24%. But now, the output side of the VCSEL emits greater than 4/5 the total light, or again with approximately 20% DQE.

A simulation has been performed to calculate the change in refractive index required to produce the change in back mirror reflectivity from 99.8% to 99.9%. If the nominal (e.g. 10°C.) refractive indices are 3.2 and 3.6, about 32.5 periods of the mirror layers are required to achieve 99.8% R. For R to increase to 99.9%, the high index needs to increase to about 3.64, assuming the low index changes negligibly. When the mirror layer refractive indices are closer, the refractive index change may be smaller. With nominal refractive indices of 3.3 and 3.6, 43 periods are needed for 99.8% reflectivity and the high-index layer needs only to increase to 3.63 for the increase to R = 99.9%. For a temperature rise from 10°C to 70°C, at a nominal wavelength of 845 nm, the bandgap of the material will shift to about 20 nm longer wavelength, and the cavity resonance will shift ^{~}5 nm longer. The differential is therefore about 15 nm relative shift between the absorption edge of the high-index material and the lasing wavelength. Comparison with published data of refractive index vs. wavelength, the slope of the refractive index is sufficiently high to cause a 0.03 or 0.04 refractive index change with a 15 nm relative shift resulting from the 60°C temperature rise. These conditions are approximated for the high-index material comprising the same material as the VCSEL active region.

In the semiconductor laser device of FIG 1, a heating means 115, e. g. a semiconductor resistor, is integrated into an electrically but not thermally isolated region of the semiconductor substrate 102. The heating means 115 has a tube-like shape and is arranged circumferential of the light emitting active region 108 and the mirrors 104, 110. The heating means 115 is supplied with supply voltage via electrical connectors 116 which are integrated into the substrate 102, electrically isolated from the substrate 102, and extending from the heating means 115 to the surface of the substrate 102. Between the interconect metal 117 and and the bottom mirrors 104 a temperature sensor 118 is arranged such that it is electrically but not thermally isolated from the substrate 102. The temperature sensor 118, e. g. a semiconductor diode, is connected to a control circuitry (not shown in FIG 1) via electrical connectors 119 which are integrated into the substrate 102, electrically isolated from the substrate 102, and extending from the temperature sensor 118 to the surface of the substrate 102.

FIG 2 is a circuit diagram illustrating an application of a laser device similar to that shown in FIG 1. A semiconductor laser device 201 comprises a vertical-cavity surface-emitting laser unit 202, a semiconductor resistor 203 as a heating means, and a semiconductor diode 204 as a temperature sensor which are integrated in one single semiconductor body such that they are thermally coupled to each other. The vertical-cavity surface-emitting laser unit 202 is driven by a driver unit 205 and supplies a current I to the vertical-cavity surface-emitting laser unit 202 which depends on an input control signal C. The current I may, for example, be pulsed dependend on signal C wherein signal C may, for example, be a pulsed or continuous signal. Dependant on the current I, a laser light beam L is generated by the vertical-cavity surface-emitting laser unit 202.

The semiconductor resistor 203 is supplied with a heater supply voltage which is provided by a heating control circuitry 206 and varyied according to the operating temperature of the laser device 201. If the temperature increases, the voltage decreases and vice versa. The operating temperature is obtained by diode 204 which is connected to the heating control circuitry 206 and operated as a temperature sensor. In this way, a constant operating temperature of the laser device 201 and, in particular the light emitting material, is maintained wherein said constant operating temperature is below the highest admissible operating temperature and above the highest operating temperature generated by the light emitting material alone, i. e. if the heating means is switched off and the ambient temperature is at its maximum occurring value. The highest admissible operating temperature is the highest operating temperature causing no damage to the laser device 201. The constant operating temperature may be, for example, 10% to 20% below the highest admissible operating temperature. As the operating temperature is constant, the temperature dependency of the laser device has no effect.

FIG 3 is a circuit diagram illustrating a further application of a laser device. A semiconductor laser device 301 comprises a vertical-cavity surface-emitting laser unit 302, a power transistor 303 as a heating means, and a sensing transistor 304 as a temperature sensor which are integrated in one single semiconductor body such that they are thermally coupled to each other. The vertical-cavity surface-emitting laser unit 302 is driven by a driver unit 305 and supplies a current I to the vertical-cavity surface-emitting laser unit 302 which depends on an input control signal C. The current I may, for example, be pulsed dependend on signal C wherein signal C may, for example, be a pulsed or continuous signal. Dependant on the current I, a laser light beam L is generated by the vertical-cavity surface-emitting laser unit 302.

The power transistor 303 is supplied with a supply voltage V and is controlled by a heating control circuitry 306, such that the current through transistor 303 is varied according to the operating temperature of the laser device 301. If the temperature increases the current decreases and vice versa. The operating temperature is obtained by the sensing transistor 304 which is connected to the heating control circuitry 306 and operated as a temperature sensor. In this way, a constant operating temperature of the laser device 301 and, in particular, the light emitting material is maintained wherein said constant operating temperature is below the highest admissible operating temperature and above the highest operating temperature generated by the light emitting material alone. As the operating temperature is constant, the temperature dependency of the laser device has no effect.

In the arrangement of FIG 3, the heating control circuitry 306 is integrated into the semiconductor body (substrate) of the laser device 301. Thus, no further external circuitry is necessary to maintain a constant operating temperature. The only additional means is a further pin to provide the supply voltage V for the heating control circuitry 306.

Although various examples of the invention have been disclosed, it will be apparent to those skilled in the art that various changes and modifications can be made which will achieve some of the advantages of the invention without departing from the spirit and scope of the invention. It will be obvious to those reasonably skilled in the art that other components performing the same functions may be suitably substituted. Such modifications to the inventive concept are intended to be covered by the appended claims.

## Claims

1. A semiconductor laser device comprising:
a light emitting material;
means for causing said light emitting material to emit light;
at least two mirrors disposed on opposite sides of said light emitting material thereby forming an optical cavity inside which lasing occurs and from which output power is emitted;
heating means thermally coupled to said light emitting material for heating said light emitting material; and
heating control means electrically connected to said heating means and thermally connected to said light emitting material for maintaining a constant operating temperature of said light emitting material; said constant operating temperature is below the highest admissible operating temperature and above the highest operating temperature generated by the light emitting material alone.

2. The semiconductor laser device of claim 1 wherein said semiconductor laser device is a vertical-cavity surface-emitting laser device.

3. The semiconductor laser device of claim 1 or 2 wherein the heating control means comprises at least one temperature sensor thermally coupled to said light emitting material.

4. The semiconductor laser device of claim 3 wherein said temperature sensor is a semiconductor device.

5. The semiconductor laser device of one of claims 1-4 wherein the heating means is a semiconductor device.

6. The semiconductor laser device of claim 4 or 5 wherein said light emitting material and/or said temperature sensing semiconductor device and/or said heating semiconductor device are integrated into a semiconductor chip.

7. The semiconductor laser device of claim 3 wherein said heating control means comprises control circuitry integrated into said semiconductor chip.

8. The semiconductor laser device of one of claims 1-7 wherein at least said light emitting material and the heating means are thermally isolated from the vicinity.

9. The semiconductor laser device of one of claims 1-8 wherein said constant operating temperature is above the highest operating temperature generated by the light emitting material alone at a maximum occurring ambient temperature.

10. The semiconductor laser device of one of claims 1-9 further comprising a second heating means connected to said heating means and thermally connected to said light emitting material.

11. The semiconductor laser device of one of claims 1-10 wherein the first and/or second heating means is/are thermally coupled to at least one of the mirrors.

12. The semiconductor laser device of one of claims 1-11 comprising more than 2 mirrors.

13. The semiconductor laser device of one of claims 1-12 wherein the cavity length is short enough for the laser to emit in only a single longitudinal mode.

14. The semiconductor laser device of one of claims 1-13 wherein the difference in refractive indices in the non-output mirror materials increases with increasing temperature.

15. The semiconductor laser device of one of claims 1-14 wherein one of the mirrors comprises the same material as the light emitting material.
